(19) Europäisches Patentamt
European Patent Office
Office européen des brevets

(11) **EP 0 598 974 B1**

(12) **EUROPEAN PATENT SPECIFICATION**

(45) Date of publication and mention
of the grant of the patent:
**08.04.1998 Bulletin 1998/15**

(51) Int Cl.$^6$: **G11C 16/06**

(21) Application number: **93100871.8**

(22) Date of filing: **21.01.1993**

(54) **Semiconductor integrated circuit**

Integrierte Halbleiterschaltung

Circuit intégré à semi-conducteurs

(84) Designated Contracting States:
**DE FR GB**

(30) Priority: **24.11.1992 JP 313585/92**

(43) Date of publication of application:
**01.06.1994 Bulletin 1994/22**

(73) Proprietor: **MITSUBISHI DENKI KABUSHIKI
KAISHA
Chiyoda-ku Tokyo (JP)**

(72) Inventor: **Yamaguchi, Atsuo,
c/o Mitsubishi Denki K.K.
Itami-shi, Hyogo 664 (JP)**

(74) Representative: **Tiedtke, Harro, Dipl.-Ing. et al
Patentanwaltsbüro
Tiedtke-Bühling-Kinne & Partner
Bavariaring 4
80336 München (DE)**

(56) References cited:
**EP-A- 0 376 285**

• **PATENT ABSTRACTS OF JAPAN vol. 16, no. 554
(E-1293) 25 November 1992 & JP-A-04 211 155
(MATSUSHITA ELECTRONICS CORP.) 3 August
1992**
• **IEEE JOURNAL OF SOLID-STATE CIRCUITS.,
vol.27, no.11, November 1992, NEW YORK US
pages 1540 - 1545 UMEZAWA ET AL 'A 5V-only
operation 0.6um flash EEPROM with row
decoder scheme in triple-well structure'**
• **IEICE TRANSACTIONS, vol.E75-C, no.4, April
1992, TOKYO JP pages 472 - 479 KUO ET AL 'A
512kb flashEEPROM embedded in a 32-b
microcontroller'**
• **PATENT ABSTRACTS OF JAPAN vol. 12, no. 420
(E-679) (3267) 8 November 1988 & JP-A-63 157
464 (MATSUSHITA ELECTRONICS CORP.) 30
June 1988**

# Description

## BACKGROUND OF THE INVENTION

### FIELD OF THE INVENTION:

The present invention relates to a semiconductor integrated circuit as indicated in the preamble of claims 1 or 3. It relates, in particular, to a semiconductor integrated circuit for a microcomputer having, for example, a built-in EEPROM.

### DESCRIPTION OF THE RELATED ART:

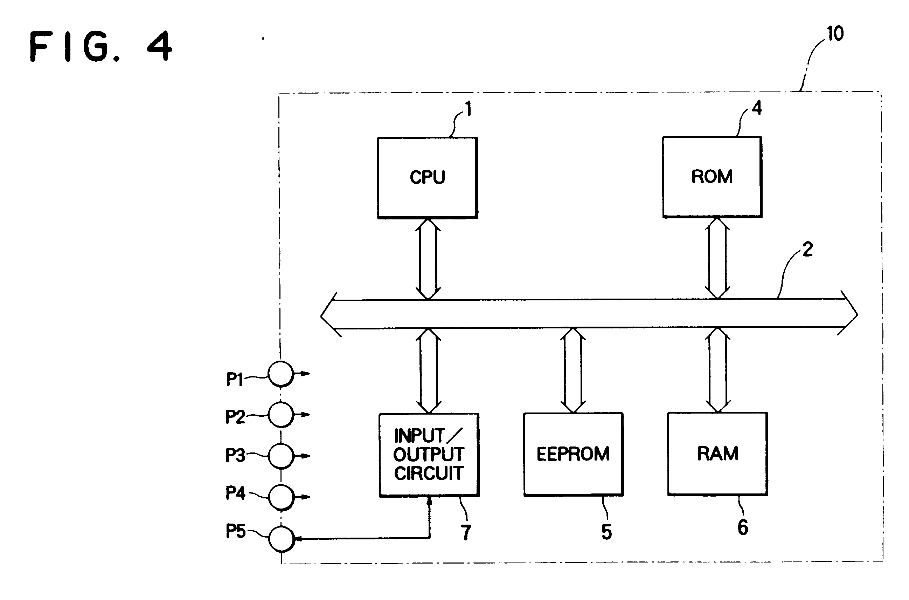

Referring to Figs. 4 to 9 and taking a semiconductor integrated circuit for a microcomputer having a built-in EEPROM as an example, the constructions and operations of the EEPROM and its peripheral circuits will be described.

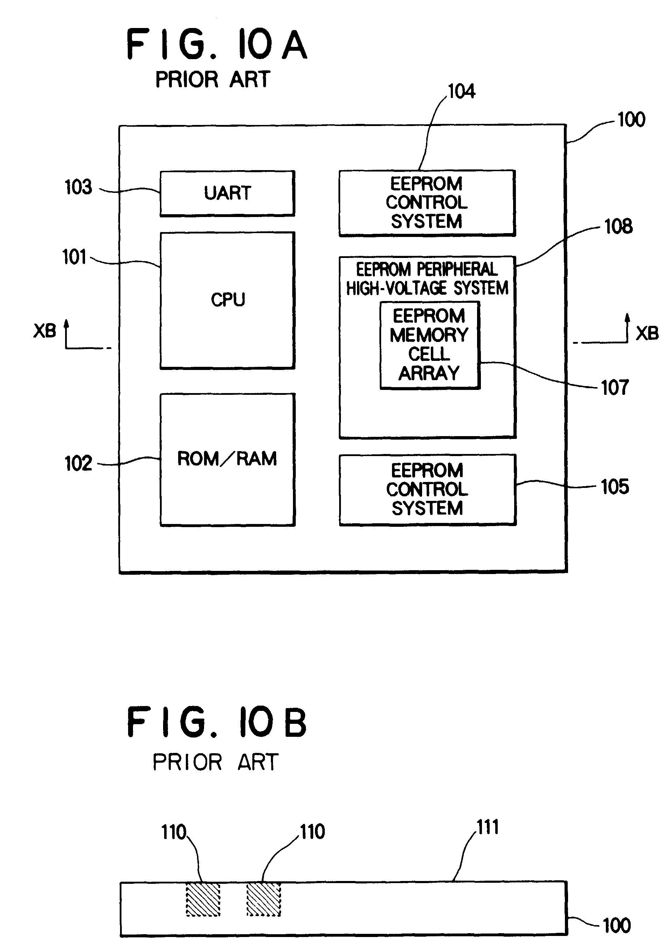

Fig. 4 is a block diagram which schematically shows the construction of an IC card microcomputer having a built-in electrically erasable programmable read only memory (EEPROM). In Fig. 4, 10 denotes an IC card or a microcomputer for data processing. In the microcomputer 10, 1 denotes a central processing unit (CPU) that performs computation and control necessary for data processing; that is, executes and controls programs for data processing. 4 denotes a ROM serving as a program memory that contains programs necessary for data processing; that is, programs for executing various functions a card user uses in practice. 5 denotes a nonvolatile EEPROM serving as a personal information memory in which card user's personal information are written. 6 denotes a RAM serving as a temporary memory that contains data necessary for data processing temporarily. 7 denotes an input/output circuit serving as an input/output unit for inputting and outputting data from and to external units. 2 denotes a system bus for interconnecting the above components. P1 represents a positive power supply input pin. P2 represents a negative power supply ground pin. P3 represents a reset pin for inputting a reset signal that initializes the CPU 1. P4 represents a clock pin for inputting a clock signal. P5 represents an input/output pin for inputting and outputting data. The input/output pin P5 is connected with the input/output circuit 7. The input/output circuit 7 is connected to the system bus 2. The input/output circuit 7 inputs and outputs data from and to external units (not shown) via the input/output pin P5.

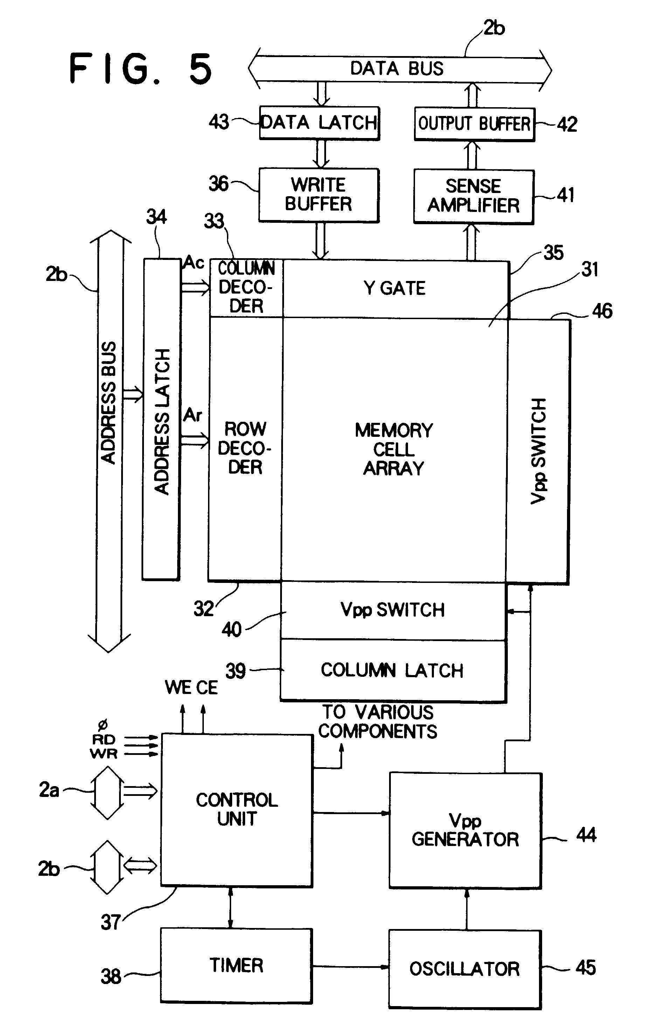

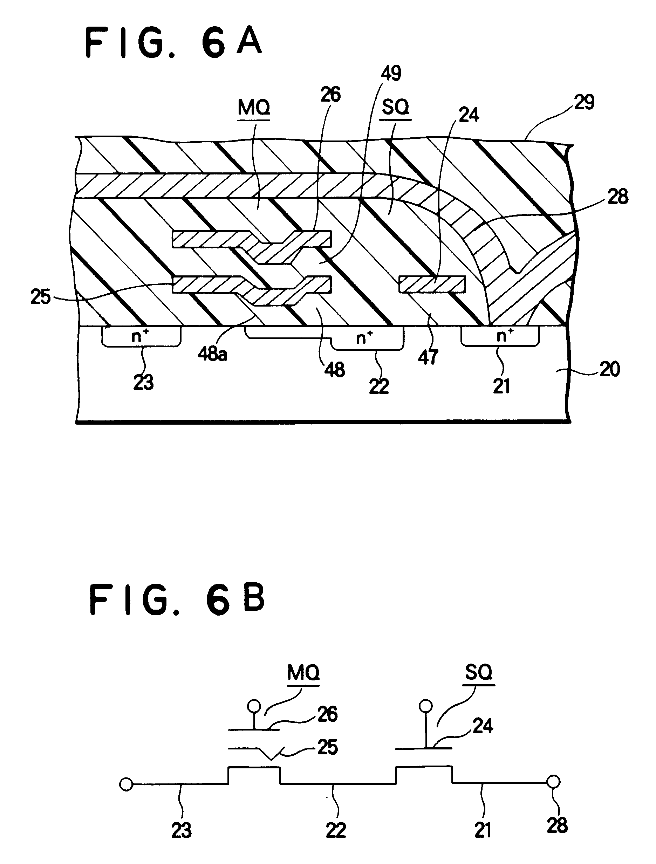

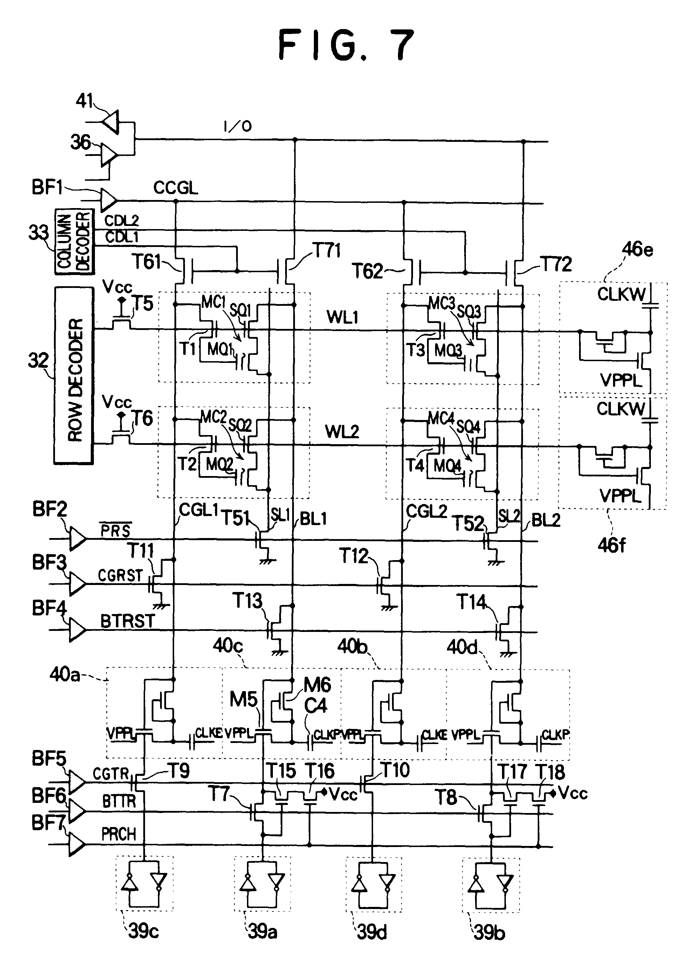

Fig. 5 is a block diagram showing an overall construction of an EEPROM. In Fig. 5, 31 denotes a memory cell array in which memory cells are arranged in the form of a matrix (See Figs. 6 and 7), and connected to word lines in rows and to bit lines in columns (See Fig. 7). 2a denotes an address bus, and 2b, a data bus. These buses are included in a system bus. A word line is selected by a row decoder 32, while a bit line is selected by a column decoder 33. The row decoder 32 sets a word line at a high level and the other word lines at a low level according to a row address Ar fetched via an address latch 34. The column decoder 33 selectively turns on a Y gate 35 according to a column address Ac fetched via the address latch 34, thus electrically coupling between a write buffer 36 and a bit line. The row decoder 32 and column decoder 33 are activated or inactivated under the control of a control unit 37. The address latch 34 fetches an address signal on the basis of an output of the control unit 37, and outputs a row address Ar and a column address Ac to the row decoder 32 and column decoder 33.

The control unit 37 uses a timer 38 to set a pulse duration of a given signal, and controls the activation or inactivation of an oscillator 45, a Vpp generator 44, a column latch 39, Vpp switches 40 and 46, a sense amplifier 41, the row decoder 32, and the column decoder 33. Based on a control clock signal $\phi$ and a write signal WR, the control unit 37 causes the data latch 43 to latch data to be written over the data bus 2b, then supplies the data to the write buffer 36.

When activated, the column latch 39 latches or temporarily holds write data placed on bit lines. When activated, the Vpp switches 44 and 46 boost the high-level signals on a bit line or a control gate line connected to the column latch 39 (See Fig. 7), and a word line connected to the row decoder 32 up to a high voltage Vpp. When activated, the sense amplifier 41 amplifies the data of a memory cell included in the memory cell array 31, and supplies the amplified data to the output buffer 42. Based on the output of the control unit 37, the output buffer 42 places data read from the sense amplifier 41 as read data on the data bus 2b. The control unit 37 controls the address latch 34 and output buffer 42 on the basis of the control clock signal $\phi$ and read signal RD.

Figs. 6A and 6B show a memory cell included in a memory cell array 31 of an EEPROM shown in Fig. 5. Fig. 6A shows a cross-sectional structure. Fig. 6B shows an equivalent circuit of Fig. 6A. As shown in Figs. 6A and 6B, the memory cell is made up of a memory transistor MQ and a selection transistor SQ. As shown in Fig. 6A, $n^+$ diffused regions 21 to 23 are formed by selectively diffusing n-type impurities over a p-type semiconductor substrate 20. 29 denotes an insulating layer. A gate 24 is formed between the $n^+$ diffused regions 21 and 22, and separated from the $n^+$ diffused regions 21 and 22 by an oxide film 47. A floating gate 25 is formed between the $n^+$ diffused regions 22 and 23 so that it will extend from above part of the $n^+$ diffused region 22, and separated from the $n^+$ diffused regions 22 and 23 by an oxide film 48. The portion of the floating gate 25 above the $n^+$ diffused region 22 has a concave structure. The oxide film 48 beneath the concave portion serves as a tunnel oxide film 48a of about 100 angstroms thick. A control gate 26 is formed above the floating gate 25 with an oxide film 49 between and has a concave portion in the same manner as the floating gate 25. A bit line 28 made of an aluminum layer is extending from the n+ diffused region 21.

In the memory cell having the foregoing construction, as shown in Fig. 6B, an enhancement-mode selection transistor SQ is connected in series with a memory transistor MQ whose threshold voltage is variable. That is to say, the selection transistor SQ uses the gate 24 as the gate, the n+ diffused region 21 as the drain, and the n+ diffused region 22 as the source. The memory transistor MQ is configured using the floating gate 25 and the control gate 26 as the gate, the n+ diffused region 22 as the drain, and the n+ diffused region 23 as the source.

Writing the memory transistor MQ is, in principle, achieved as follows: an electric field of about 10 MV/cm is developed on the tunnel oxide film 48a by applying a high voltage to either the drain 22 or control gate 26, and grounding either of the drain 22 or control gate 26 to which a high voltage is not applied, then electrons are injected at or drained from the floating gate 25. Specifically, when electrons are injected at the floating gate 25 of the memory transistor MQ, the threshold voltage shifts to be positive. When electrons are drained from the floating gate 25, the threshold voltage shifts to be negative. The positive and negative threshold voltages are represented as information 1 or 0. Thereby, nonvolatile writing is accomplished.

On the other hand, reading information from the memory transistor MQ is, in principle, achieved as follows: a high-level signal is applied to the gate 24 of the selection transistor SQ of a selected memory cell, the source 23 of the memory transistor MQ is set to the ground potential, then a read voltage VCG of, for example, about 0 V is applied to the control gate 26. At this time, if the threshold voltage of the memory transistor MQ is positive, the memory transistor MQ is turned off. If the threshold voltage is negative, the memory transistor MQ is turned on. When the memory transistor MQ is turned on, current flows from the bit line 28 into the ground level via the selection transistor SQ and memory transistor MQ. The sense amplifier 41 (See Fig. 5) connected to the bit line 28 converts the current into a voltage. Thus, a signal is detected, and reading is accomplished. The gate 24 of a selection transistor SQ of a memory cell that is not selected is provided with a low-level signal. This turns off the memory transistor MQ. Therefore, even when the memory transistor MQ has a negative threshold voltage, current will not flow from the bit line 28 to the ground level.

Fig. 7 is a circuit diagram showing a construction of peripheral circuits of a memory cell array 31 of an EEPROM shown in Fig. 5. In Fig. 7, four 1-bit 1-byte memory cells MC1, MC2, MC3, and MC4 alone are shown for simplification. In the following description, signal lines and signals running on the signal lines are expressed with the same numerals. The memory cells MC1 to MC4 are, as shown in Fig. 6, made up of memory transistors MQ1, MQ2, MQ3, and MQ4, and selection transistors SQ1, SQ2, SQ3, and SQ4. The drains of the selection transistors SQ1 and SQ2 are connected to a bit line BL1. The drains of the selection transistors SQ1 and SQ2 are connected to a bit line BL2. The sources of the memory transistors MQ1 and MQ2 are connected to a source line SL1. The sources of the memory transistors MQ3 and MQ4 are connected to a source line SL2.

The source lines SL1 and SL2 are grounded via transistors T51 and T52 whose gates are provided with a reverse program cycle selection signal $\overline{PRS}$. The control gates of the memory transistors MQ1 and MQ2 are connected to a control gate line CGL1 via byte selection transistors T1 and T2. Similarly, the control gates of the memory transistors MQ3 and MQ4 are connected to a control gate line CGL2 via byte selection transistors T3 and T4. The gates of the transistors T1 and T3, and those of the selection transistors SQ1 and SQ3 are connected to a word line WL1. The gates of the transistors T2 and T4, and those of the selection transistors SQ2 and SQ4 are connected to a word line WL2. Ends of the word lines WL1 and WL2 are connected to a row decoder 32 via high-voltage cutoff transistors T5 and T6 whose gates are provided with a supply voltage Vcc.

Ends of bit lines BL1 and BL2, and those of the control gate lines CGL1 and CGL2 are connected to column latches 39a, 39b, 39c, and 39d via transistors T7, T8, T9, and T10. The other ends of the control gate lines CGL1 and CGL2 are connected to a common control gate line CCGL via Y-gate transistors T61 and T62. The other ends of the bit lines BL1 and BL2 are connected to an input/output line I/O via Y-gate transistors T71 and T72. The gates of the transistors T61 and T71 are connected to an output line CDL1 of a column decoder 33. Similarly, the gates of the transistors T62 and T72 are connected to an output line CDL2. The common control gate line CCGL is connected to a buffer BF1. The input/output line I/O is connected to a write buffer 36 and to a sense amplifier 41. The control gate lines CGL1 and CGL2, the bit lines BL1 and BL2, and the word lines WL1 and WL2 are connected to Vpp switches 40a to 40d, 44e, and 44f. The Vpp switches 40a to 40d, 44e, and 44f are connected to a high-voltage line VPPL over which a high voltage of about 15 to 20 V is supplied. The Vpp switches 40a to 40d, 44e, and 44f fetch erasing clock signals CLKE, program clock signals CLKP, and word line clock signals CLKW. In response to these clock signals, the connected control gate lines CGL1 and CGL2, bit lines BL1 and BL2, and word lines WL1 and WL2 are boosted to a high voltage Vpp when they are high. Even when the word lines WL1 and WL2 are boosted to the high voltage Vpp, the transistors T5 and T6 whose gates are provided with a supply voltage Vcc prevents the high voltage Vpp from entering the row decoder 32.

A bit signal transfer control signal BTTR is fed to the gates of the transistors T7 and T8. A control gate signal transfer control signal CGTR is fed to the gates of the transistors T9 and T10. When these signals are high, signals are transferred between the bit line BL1 or BL2, or the control gate line CGL1 or CGL2, and the column latch 39a, 39b, 39c, or 39d. Even when the bit line BL1 or BL2, or the control gate line CGL1 or CGL2 is boosted to the high voltage Vpp, since the gates of the transistors T7 to T10 are at the level of Vcc, the high voltage Vpp will not be applied to the column latch 39a, 39b, 39c, or 39d.

Transistors 11 and 12 are connected to the control gate lines CGL1 and CGL2. A control gate line reset signal CRGST is fed to the gates of the transistors T11 and T12. When the control gate line reset signal CRGST is driven high, the control gate lines CGL1 and CGL2 become low. Transistors T13 and T14 are connected to the bit lines BL1 and BL2. A bit line reset signal BTRST is fed to the gates of the transistors T13 and T14. When the bit line reset signal BTRST is driven high, the bit lines BL1 and BL2 become low.

Transistors T15 and T17 are connected to the bit lines BL1 and BL2. Transistors T16 and T18 are connected to the transistors T15 and T17. The gates of the transistors T15 and T17 are connected with the column latches 39a and 39b. A pre-charge signal PRCH is fed to the gates of the transistors T16 and T18. When the signals at the column latches 39a and 39b are high, if the pre-charge signal PRCH is driven high, the bit lines BL1 and BL2 become high.

The reverse program cycle selection signal $\overline{PRS}$, control gate line reset signal CGRST, bit line reset signal BTRST, control gate signal transfer control signal CGTR, bit signal transfer control signal BTTR, and pre-charge signal PRCH are driven by buffers BF2, BF3, BF4, BF5, BF6, and BF7.

Next, referring to Fig. 7, an EEPROM reading operation will be described. First, a row decoder 32 and a column decoder 33 select a word line WL, a control gate line CGL, and a bit line BL. Herein, it is assumed that a memory cell MC1 is specified because a word line WL1 is selected, and a control gate line CGL1 and a bit line BL1 are selected by turning on transistors T61 ant T72. A reverse program cycle selection signal $\overline{PRS}$ is driven high, and source lines SL1 and SL2 are grounded. A control unit 37 inactivates column latches 30a to 30d, Vpp switches 40a to 40d, 46e, and 46f, and a write buffer 36. Then, the control unit 37 causes a buffer BF1 to place 0 V on a common control gate line CCGL, so that the 0 V will be applied to a control gate of a memory transistor MQ1 via a transistor T61 and a transistor T1. At this time, the memory transistor MQ1 is turned off when its threshold voltage is positive. The memory transistor MQ1 is turned on when its threshold voltage is negative. Depending on the on or off state of the memory transistor MQ1, the presence or absence of current flowing over the bit line BL1 is detected as a potential variation in an input/output line I/O by a sense amplifier 41. The sense amplifier outputs a read signal in which the potential variation is amplified. Thus, reading is achieved.

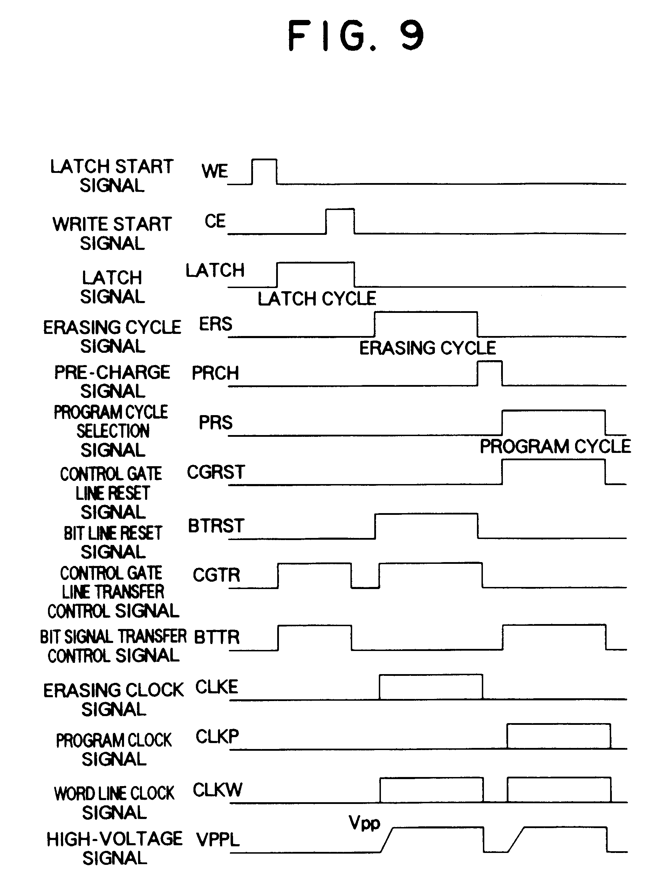

Fig. 9 is a timing chart showing various signal waveforms during EEPROM writing. Referring to Figs. 5 to 7, and 9, a writing operating will be described on the assumption that a memory cell MC1 is selected. First, when a latch signal LATCH is driven high with a latch start signal WE, a latch cycle starts. At the start of the latch cycle, a control unit 37 activates column latches 39a to 39d, a column decoder 33, and a write buffer 36. Then, a common control gate line CCGL is driven high. On the other hand, a row decoder 32 and a sense amplifier 41 are inactivated under the control of the control unit 37.

When the latch signal LATCH is high, transistors T61 and T72 selected by the column decoder 33 are turned on. Then, data in a data latch 43 (information 0 represents a high level, while information 1 represents a low level) is latched by a column latch 39b after passing through the write buffer 36, an input/output line I/O, a bit line BL1, and a transistor T7. A high-level signal is latched by the column latch 39a after passing through the common control gate line CCGL and a control gate line CGL1. Next, when a write start signal CE is driven high temporarily, the signal LATCH becomes low. Then, an erasing cycle signal ERS rises to start an erasing cycle. When the erasing cycle signal ERS is high, the erasing cycle is under way. When a program cycle selection signal PRS (i.e. a reverse signal of a reverse program cycle selection signal $\overline{PRS}$) is high, a program cycle is under way. The control unit 37 uses a timer 38 to set the pulse durations of the high-level signals ERS and PRS to given values.

During an erasing cycle, the control unit 37 activates the row decoder 32. The row decoder 32 sets a word line WL1 alone to a high level. The control unit 37 inactivates the column decoder 33. When a high voltage Vpp having a pulse duration of about 4 milliseconds is placed on a high-voltage line VPPL, the high voltage Vpp is applied to Vpp switches 40a to 40e, 46e, and 46f. Then, the control unit 37 causes a high-frequency oscillator made up of an oscillator 45 and a Vpp generator 44 to supply an erasing clock CLKE having a high frequency of several megahertz and a word line clock signal CLKW to the Vpp switches 40a and 40b, and 46e and 46f. Since the reverse program cycle selection signal $\overline{PRS}$ is high, the source lines SL1 and SL2 are grounded. In this setting, the Vpp switch 40a and 46e boost the high-level signals on the word line WL1 and control gate line CGL1 to a high voltage Vpp. Then, a tunnel effect occurs between a floating gate 25 (See Fig. 6) and a drain region ($n^+$ diffused region 22) of the memory transistor MQ1. Electrons are injected at the floating gate 25, and the threshold voltage of the memory transistor MQ1 shifts to be positive (information 1 is stored). When the erasing cycle is completed, the potential of the control gate line CGL1 is reset to a low level.

Next, the erasing cycle signal ERS rises, and the pre-charge signal PRCH becomes high. After that, the program cycle selection signal PRS rises to start a program cycle. The control unit 37 inactivates a word line clock signal CLKW and an erasing clock signal CLKE, and causes the high-frequency oscillator to supply a high-frequency program clock signal CLKP having a high frequency of several megahertz and a word line clock signal CLKW to the Vpp switches 40c and 40d, and 46e and 46f. At this time, since the reverse signal $\overline{PRS}$ is low, the source line SL1 is floating. In this setting, if a high-level signal is latched by the column latch 39a, the word line WL1 and bit line BL1 are boosted to a high voltage Vpp. A tunnel effect occurs between the floating gate 25 (See Fig. 6) and the drain region (n+ diffused region 22) of the memory transistor MQ1. Thereby, electrons are drained from the floating gate 25, and the threshold voltage of the memory transistor MQ1 shifts to be negative (information 0 is stored). On the other hand, if the column latch 39a latches a low-level signal, only the word line WL1 is boosted to the high voltage Vpp. Therefore, the threshold voltage of the memory transistor MQ1 does not vary. Thus, writing terminates.

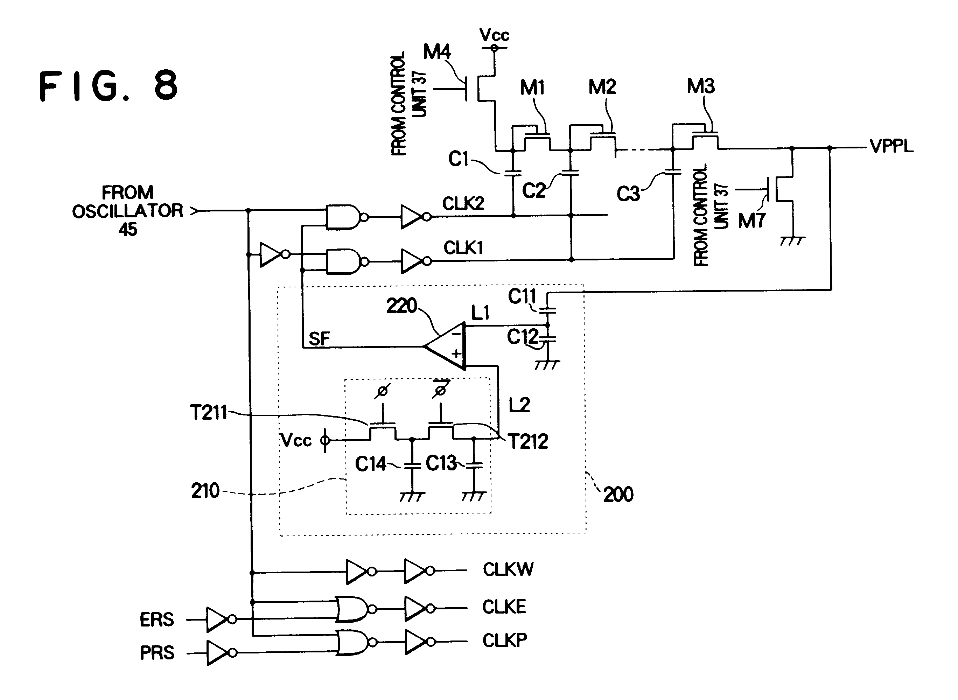

Next, a circuit diagram showing the internal construction of the Vpp generator (high-voltage generator) 44 shown in Fig. 5 will be shown in Fig. 8 and described.

The gate and drain of a transistor M1 are tied with each other, and a capacitor C1 is connected to the junction therebetween. The source of the transistor M1 is connected with the drain of a transistor M2 at the next step. The gate and drain of the transistor M2 are tied with each other, and a capacitor C2 is connected to the junction therebetween. Clock signals CLK2 and CLK1 that are 180° out of phase with each other are fed to the other ends of the capacitors C1 and C2 connected with the drains of the transistors M1 and M2. Transistors are concatenated at multiple steps in the above manner. Then, the drain of the transistor M1 at the first step is connected with the source of a transistor M4. The drain of the transistor M4 is connected with a supply voltage Vcc, and the gate of the transistor M4 is controlled with an output signal of a control unit 37. Source current of a transistor M3 at the final step is provided as an output of a charge pump. A high voltage Vpp that is an output of the Vpp generator 44 is fed to the Vpp switches 40a to 40d, 46e and 46f over a high-voltage line VPPL. According to a control signal, a control gate line CGL1 or CGL2, a bit line BL1 or BL2, and a word line WL1 or WL2 are boosted to a high voltage. A transistor M7 discharges a high voltage Vpp in response to a signal sent from the control unit 37.

A waveform shaping circuit 200 will be described later.

Next, the construction of a high-voltage switch shown in Fig. 7 will be described by taking the case of a high-voltage switch 40c. The other high-voltage switches have the same construction as the high-voltage switch 40c, which, therefore, will not be described.

A high voltage is fed to a drain of a transistor M5. The source of the transistor M5 is connected with a drain of a transistor M6 that has undergone diode connection, and to one electrode of a capacitor C4. In the diode connection, a gate and a drain of a transistor are tied so that the source and drain of the transistor will constitute a diode. The source of the transistor M6 is connected with the gate of the transistor M5 and to a bit line BL1. A program clock signal CLKP is fed to the other electrode of the capacitor C4. Clocks that are in phase with each other are fed to clock signal lines CLKP and CLK2. A clock that is 180° out of phase with the clocks is fed to a clock signal line CLK1 (See Fig. 8).

Next, the operations of a Vpp generator 44 and a high-voltage switch 40c will be described. In a Vpp generator 44 shown in Fig. 8, when a clock signal CLK2 is low, a capacitor C1 is charged. Then, the CLK2 rises. The charge applied to the capacitor C1 passes through a transistor M1 and enters a capacitor C2. Next, the CLK2 falls and a CLK1 rises. Then, the capacitor C1 is charged. At this time, a charge applied to the capacitor C2 is sent to a capacitor at the nest step. However, since a transistor M2 acts as a diode, the charge will not be sent to the capacitor C1. Thus, charges are sent subsequently according to the clock signals CLK1 and CLK2. As a result, a boosted voltage is fed to an output of a charge pump.

In a high-voltage switch 40c of Fig. 7, when a column latch 39a is high and a signal BTTR is high, a signal on a bit line BL1 rises. When a signal CLKP is low, a transistor M5 is turned on. Then, a capacitor C4 is charged with a high voltage Vpp until the transistor M5 is turned off. Then, when the signal CLKP rises, charges of the capacitor C4 flow through a transistor M6 to the bit line BL1. Then, the gate potential of the transistor M5 connected to the bit line BL1 goes up, and the capacitor C4 is charged with the high voltage Vpp until the transistor M5 is turned off (at this time, the signal CLKP is low). This operation is repeated. Thus, the bit line BL1 is boosted to the high voltage Vpp according to the signal sent from the column latch 39a.

The other Vpp switches operate similarly to the high-voltage switch 40c.

Clock signals CLK1, CLK2, CLKW, CLKE, and CLKP are generated on the basis of a signal sent from the oscillator 45 as well as the erasing cycle signal ERS and program cycle selection signal PRS.

As described above, a high voltage is applied to a control gate or drain of a memory transistor MQ via a selection transistor SQ.

However, when an output of a high-voltage (Vpp) switch is applied to a control gate 26 or to a drain 22 of a memory transistor MQ as it is, the leading edge of an output wave of a high voltage Vpp rises abruptly because of its small time constant. This greatly damages a tunnel oxide film 48a. At the worst, the tunnel oxide film 48a is destroyed.

To alleviate the damage to the tunnel oxide film 48a, the time constant of the leading edge must be large enough. For this purpose, a waveform shaping circuit is installed in the Vpp generator 44.

Fig. 8 further shows a waveform shaping circuit 200.

In Fig. 8, an output voltage Vpp of a Vpp generator 44 is divided using capacitors C11 and C12. The divided output is fed as a sample signal to a negative input port of a comparator 220 over a connection line L1. On the other hand, an output voltage of a supply voltage Vcc is fed to a positive input port of the comparator 220 via a switched capacitor 210 over a connection line L2.

The switched capacitor 210 is made up of transistors T211 and T212 connected in series between the supply voltage Vcc and connection line L2, a capacitor C14 one of whose electrodes is connected to the junction between the transistors T211 and T212 and the other of whose electrodes is grounded, and a capacitor C13 connected between the connection line L2 and the ground. A clock signal φ and a reverse clock signal φ̄ are fed to the gates of the transistors T211 and T212. The drain of the transistor T212 is connected with the supply voltage Vcc, and the source of the transistor T212, to the connection line L2.

In the foregoing construction, the waveform of the leading edge of an output voltage of a supply voltage Vcc is reshaped according to the clock signal φ of the switched capacitor 210 and the time constant determined by the capacitors C13 and C14. A voltage whose waveform is reshaped is fed as a reference voltage to a positive input port of the comparator 220.

The comparator 220 generates a feedback signal SF to indicate a difference of the aforesaid output voltage of the Vpp generator 44 from the reference voltage. Based on the feedback signal SF, the clock signals CLK1 and CLK2 are controlled so that the output of the Vpp generator 44 will be boosted to a high voltage while having a leading edge shaped similarly to the reference voltage.

The constructions and operations of an EEPROM and its peripheral circuits have been described so far. Fig. 10 shows a construction of a semiconductor substrate on which a conventional semiconductor integrated circuit is formed to provide a microcomputer having a built-in EEPROM. Fig. 10A shows a layout of functional blocks formed on a semiconductor substrate. Fig. 10B schematically shows a XB-XB cross section of Fig. 10A. In Figs. 10A and 10B, 100 denotes a semiconductor substrate on which a semiconductor integrated circuit is formed. 101 denotes a CPU. 102 denotes a ROM or RAM. 103 denotes a universal asynchronous receiver/transmitter (UART) serving as an input/output unit. 104 and 105 denote EEPROM control systems. 107 denotes an EEPROM memory cell array. 108 denotes an EEPROM peripheral high-voltage system. 110 denotes an n-well region. 111 is a p-type substrate region.

The EEPROM memory cell array 107 corresponds to a memory cell array 31 in Fig. 5 and to four portions each of which is made up of a memory cell MC and a transistor T and enclosed with a dashed line in Fig. 7. The peripheral high-voltage system 108 corresponds to Vpp switches 40 and 46, a Y gate 35, and part of a Vpp generator 44 (high-voltage unit), which are shown in Fig. 5. Alternatively, the peripheral high-voltage system 108 corresponds to the peripheral high-voltage system 108 includes Vpp switches 401 to 40d, 46e, and 46f, and transistors T5 to T18, T51, T52, T61, T62, T71, and T72, which are shown in Fig. 7, as well as transistors M1 to M4 and M7, and capacitors C1 to C3, C11, and C12, which belong to a Vpp generator shown in Fig. 8. Then, the EEPROM control systems 104 and 105 correspond to a write buffer 36, a sense amplifier 41, an output buffer 42, a data latch 43, a column decoder 33, a row decoder 32, an address latch 34, a column latch 39, a control unit 37, a timer 38, an oscillator 45, and the remaining portion of the Vpp generator 44, which are shown in Fig. 5. Alternatively, the EEPROM control systems 104 and 105 correspond to a write buffer 36, a sense amplifier 41, buffers BF1 to BF7, a column decoder 33, a row decoder 32, and column latches 39a to 39d, which are shown in Fig. 7, as well as a waveform shaping circuit, which is shown in Fig. 8, except capacitors C11 and C12.

As illustrated, in a conventional semiconductor integrated circuit for a microcomputer having a built-in EEPROM, the n-well region 110 is created on part of the semiconductor substrate 100. A p-channel transistor is formed in the n-well region, and an n-channel transistor is formed in the remaining p-type substrate region. Then, the CPU 101, ROM/RAM 102, UART 103, and EEPROM control systems 104 and 105, which are shown in Fig. 10A, are configured as CMOS circuits. The EEPROM memory cell array 107 and peripheral high-voltage system 108 are formed in the p-type substrate region 111.

## SUMMARY OF THE INVENTION

A conventional semiconductor integrated circuit for a microcomputer having a built-in EEPROM has the aforesaid construction. To shorten a development time and evolve a variety of products, a microcomputer having a built-in EEPROM must be interchangeable with a normal microcomputer without an EEPROM so that the pattern layout of the normal microcomputer can be used as it is. Incorporation of a highly-integrated microcomputer is a must in reducing a chip size.

To further facilitate micromachining, a concentration of impurities in a semiconductor substrate must be increased. A semiconductor integrated circuit for a microcomputer without a latest EEPROM has a twin-well structure in which a n-well region and a p-well region are created. However, a high concentration of impurities in a semiconductor substrate intensifies a substrate effect. If a circuit having a built-in EEPROM, which has been described as a prior art, is formed on a semiconductor substrate having a twin-well structure, the circuit does not operate. A substrate effect is an effect that as a source potential rises, a threshold voltage of a transistor, Vth, increases. In an EEPROM in which a source potential is a high voltage, especially, the rise in source potential must be held as low as possible. For this reason, it is difficult for prior arts to incorporate an EEPROM in a semiconductor integrated circuit for a microcomputer that has a twin-well structure enabling high integration of circuits.

The present invention attempts to solve the aforesaid problem. An object of the present invention is to provide a semiconductor integrated circuit in which an EEPROM is incorporated in a microcomputer having a latest twin well structure that enables high integration of circuits.

To achieve the forgoing object, the first embodiment of the present invention provides a single semiconductor integrated circuit comprising at least an EEPROM memory array in which a plurality of memory cells each including a nonvolatile memory transistor in or from which data can be written or erased electrically are arranged in the form of a matrix, a means that generates a high voltage necessary for writing or erasing data in or from the memory cell array, a means for supplying the high voltage selectively to a memory cell, and a means that controls writing, and reading and erasing data in and from the memory cell array. Herein, a portion including the memory cell array, and the high-voltage generating means and high-voltage supplying means that constitute a peripheral high-voltage system of the memory cell array is formed on a p-type semiconductor substrate to have an NMOS structure, or on a n-type semiconductor substrate to have a PMOS structure. The control means to which no high voltage is applied is formed as a CMOS in a twin-well region using a p well and an n well that are created on the semiconductor substrate.

According to the second embodiment, in a semiconductor integrated circuit of the first invention, said portion in which the EEPROM memory cell array, and the high-voltage generating means and high-voltage supplying means that constitute a peripheral high-voltage system of the memory cell array are formed is surrounded with a p-well region or an n-well region that is of the same type as that of the semiconductor substrate.

The third embodiment provides a single semiconductor integrated circuit for a microcomputer, comprising a CPU for processing data, a ROM that contains programs, a RAM for temporarily storing data, an input/output unit for transferring data to or from external units, an EEPROM memory cell array in which a plurality of memory cells each including a nonvolatile memory transistor in or from which data can be written or erased electrically are arranged in the form of a matrix, a high-voltage generator that generates a high voltage necessary for writing or erasing data in or from the memory cell array, an EEPROM peripheral high-voltage system including a high-voltage supplier that supplies the high voltage selectively to any of the memory cells, EEPROM control systems that control writing, and reading and erasing data in and from the memory cell array under the control of the CPU, and a system bus means for interconnecting the above components. A portion which consists of the EEPROM memory cell array and the EEPROM peripheral high-voltage system and to which a high voltage is applied is formed on a p-type semiconductor substrate to have an NMOS structure, or on a n-type semiconductor substrate to have a PMOS structure. The CPU, ROM, RAM, input/output unit, and EEPROM control systems to which no high voltage is applied are formed as CMOSs in a twin-well region using a p well and an n well that are created on the semiconductor substrate.

The fourth embodiment provides a semiconductor integrated circuit for a microcomputer, wherein the portion in which the EEPROM memory cell array and EEPROM peripheral high-voltage system are formed is surrounded with a p-well region or an n-well region that is of the same type as that of the semiconductor substrate.

In a semiconductor integrated circuit of the first embodiment, a portion of a supply voltage Vcc system that includes a control means and to which a high voltage Vpp is not applied has a twin-well structure. This realizes a rule of 1 um or less, enables micromachining of a circuit, and improves the degree of integration. On the other hand, a portion which consists of an EEPROM memory cell array, and a high-voltage generating means and a high-voltage supplying means that constitute a peripheral high-voltage system of the memory cell array, and to which a high voltage Vpp is applied is formed, for example, on a p-type semiconductor substrate to have an NMOS structure. This minimizes a substrate effect and enables a charge pump, Vpp switches, and memory cells to operate normally.

According to the second embodiment, in the integrated circuit of the first embodiment, a p-type substrate region in which the EEPROM memory cell array, and the high-voltage generating means and high-voltage supplying means that constitute the peripheral high-voltage system of the memory cell array are formed and to which the high voltage Vpp is applied is surrounded with a p-well region and designed as small as possible. This avoids a latch-up phenomenon caused by a floating substrate.

In a semiconductor integrated circuit for a microcomputer according to the third embodiment, similarly to that according to the first embodiment, a supply voltage Vcc system which includes a CPU, a ROM, a RAM, an input/output unit, and EEPROM control systems and to which a high voltage Vpp is not applied is formed in a twin-well region. This realizes a rule of 1 μm or less, enables micromachining of a circuit, and improves a degree of integration. On the other hand, a portion which includes an EEPROM memory cell array and an EEPROM peripheral high-voltage system and to which the high voltage Vpp is applied is formed, for example, on a p-type semiconductor substrate to have an NMOS structure. This minimizes a substrate effect, and enables a charge pump, Vpp switches, and memory cells to operate normally.

According to the fourth embodiment, in an integrated circuit of the third embodiment, the p-type substrate region in which the EEPROM memory cell array and the EEPROM peripheral high-voltage system are formed and to which the high voltage Vpp is applied is surrounded with a p-well region and designed as small as possible. This avoids a latch-up phenomenon caused by a floating substrate.

BRIEF DESCRIPTION OF THE DRAWINGS

Fig. 1A shows a layout of functional blocks for a semiconductor substrate of a semiconductor integrated circuit for a microcomputer having a built-in EEPROM in which the present invention is implemented, and Fig. 1B schematically shows an IB-IB cross section of Fig. 1A;
Fig. 2 is a circuit diagram showing a construction of peripheral circuits of an EEPROM memory cell array for a semiconductor integrated circuit of the present invention;
Fig. 3 is a circuit diagram showing a construction of a Vpp generator for a semiconductor integrated circuit of the present invention;
Fig. 4 is a block diagram schematically showing a construction of a general IC card microcomputer having a built-in EEPROM;
Fig. 5 is a block diagram showing an overall construction of an EEPROM;
Fig. 6A shows a cross section of a memory cell included in a memory cell array of the EEPROM shown in Fig. 5, and Fig. 6B shows an equivalent circuit;
Fig. 7 is a circuit diagram showing a construction of peripheral circuits of a memory cell array of the EEPROM shown in Fig. 5;
Fig. 8 is a circuit diagram showing a construction of a Vpp generator shown in Fig. 5;
Fig. 9 is a timing chart of various signals during EEPROM writing; and
Fig. 10A shows a layout of various functional blocks for a semiconductor substrate of a conventional semiconductor integrated circuit for a microcomputer having a built-in EEPROM, and Fig. 10B schematically shows an XB-XB cross section of Fig. 10A.

DESCRIPTION OF THE PREFERRED EMBODIMENTS

An embodiment of the present invention will be described in conjunction with the drawings.

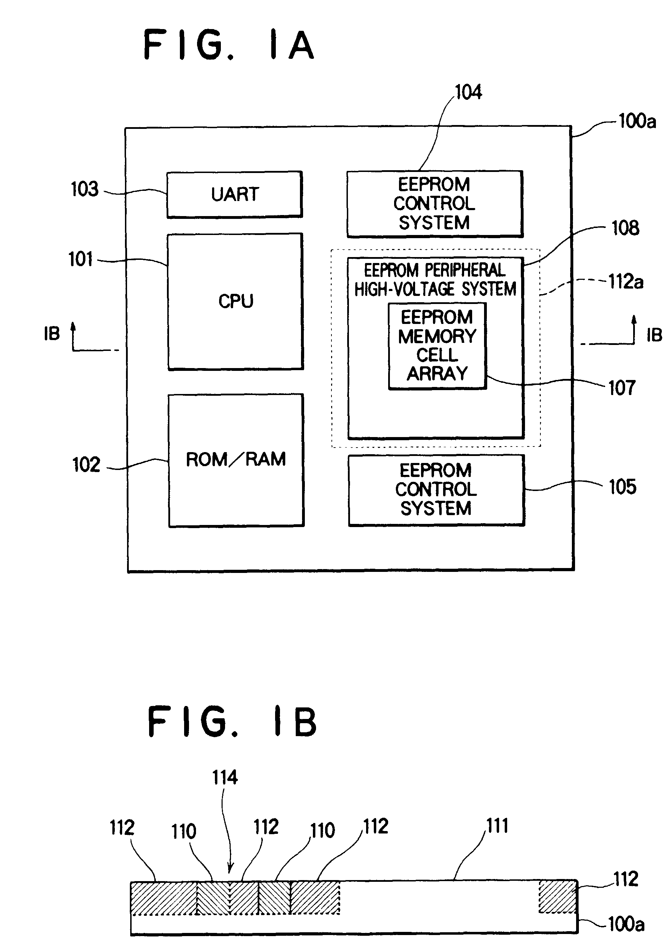

Figs. 1A and 1B show an embodiment of a semiconductor integrated circuit according to the present invention; that is, a construction of a semiconductor substrate of a semiconductor integrated circuit for a microcomputer having a built-in EEPROM in which the present invention is implemented. Fig. 1A shows a layout of various functional blocks on a semiconductor substrate. Fig. 1B schematically shows an IB-IB cross section of Fig. 1A. In this embodiment, similarly to the prior art described previously, a semiconductor integrated circuit is formed on a p-type semiconductor substrate. In Figs. 1A and 1B, 100a denotes a p-type semiconductor substrate on which a semiconductor integrated circuit is formed. 101 denotes a CPU. 102 denotes a ROM or RAM. 103 denotes a UART serving as an input/output circuit. 104 and 105 denote EEPROM control systems. 107 denotes an EEPROM memory cell array. 108 denotes an EEPROM peripheral high-voltage system. 110 denotes an n-well region. 111 denotes a p-type substrate region that is smaller than a conventional one. 112 denotes a p-well region. 114 denotes a twin-well region made up of the n-well region 110 and p-well region 112.

As shown in Figs. 1A and 1B, the CPU 101, ROM or RAM 102, UART 103, and EEPROM control systems 104 and 105 are formed as CMOSs in the twin-well region 114 made up of the n-well region 110 and the p-well region 112. On the other hand, the EEPROM memory cell array 107 and EEPROM peripheral high-voltage system 108, to which a high voltage Vpp is applied, are formed as NMOSs in the p-type substrate region 111.

The p-type substrate region 111 in which the EEPROM memory cell array 107 and EEPROM peripheral high-voltage system 108 are formed is, preferably, as indicated with a dashed line 112a in Fig. 1A, surrounded with a p-well region.

Components formed in the p-type substrate region 111 in the circuitry shown in Figs. 1A and 1B will be described.

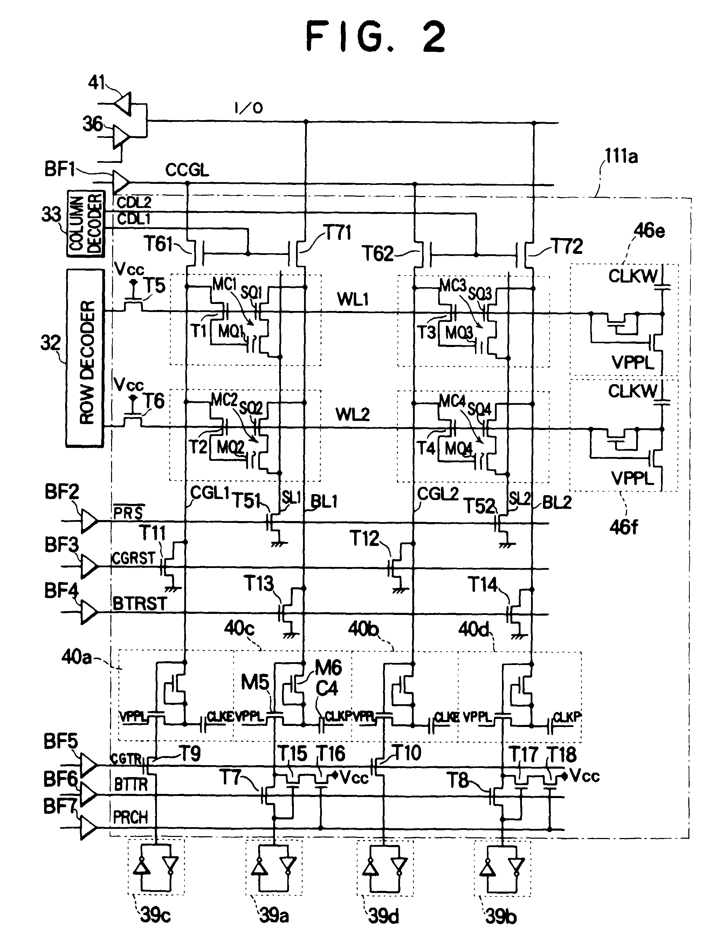

Fig. 2 shows a circuitry of peripheral circuits of an EEPROM memory cell array in a semiconductor integrated circuit of the present invention. The electrical system of the circuitry is identical to that shown in Fig. 7. In Fig. 2, a section enclosed with a dot-dash line 111a is a portion that is formed in a p-type substrate region 111 to have an NMOS structure. The section 111a includes a portion corresponding to an EEPROM memory cell array and a high-voltage supplying means for supplying a high voltage selectively to a memory cell array. The EEPROM memory cell array includes four memory cells one of which consists of, for example, a memory cell MC1 and a transistor T1 and which are enclosed with dashed lines. The high-voltage supplying means includes Vpp switches 40a to 40d, Vpp switches 46e and 46f, high-voltage cutoff transistors T5 and T6, transistors T7 and T8 for connecting column latches 39a and 39b to bit lines BL1 and BL2, transistors T9 and T10 for connecting column latches 39c and 39d to control gate lines CGL1 and CGL2, transistors T11 and T12 for grounding the control gate lines CGL1 and CGL2, transistors T13 and T14 for grounding the bit lines BL1 and BL2, pre-charge transistors T15 to T18, transistors T51 and T52 for grounding source lines SL1 and SL2, and Y-gate transistors T61, T62, T71, and T72.

On the other hand, a sense amplifier 41, a write buffer 36, various buffers BF1 to BF7, a column decoder 33, a row decoder 32, and column latches 39a to 39d constitute a supply voltage Vcc system, to which a high voltage Vpp is not applied. These components belong to the EEPROM control systems 104 and 105 shown in Fig. 1A, which, therefore, is formed as CMOSs in the twin-well region 114.

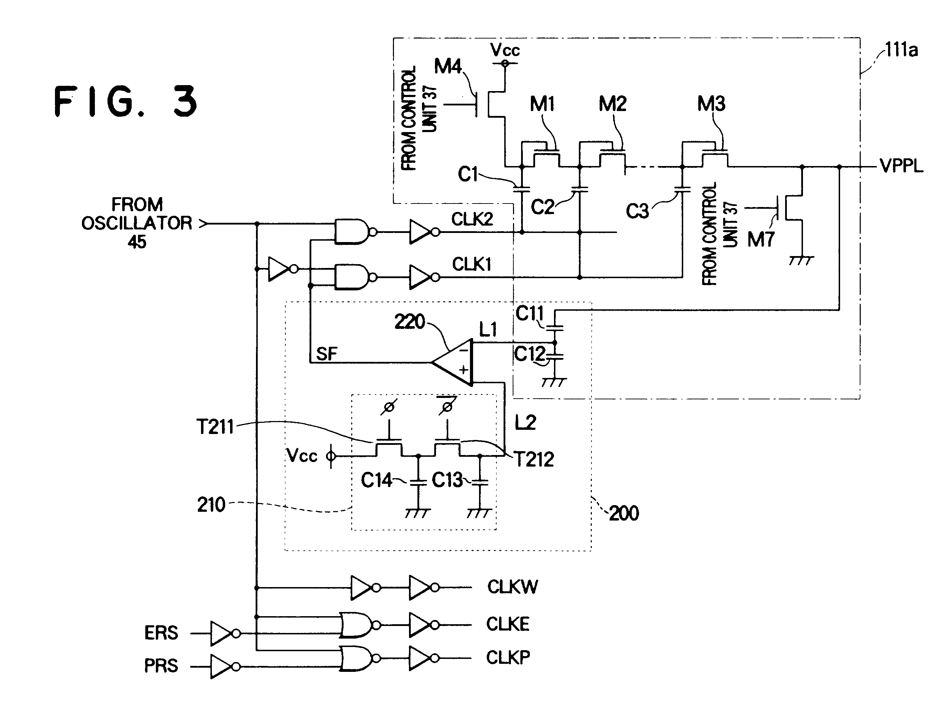

Fig. 3 shows a circuitry of a Vpp generator (high-voltage generator) 44 (See Fig. 5) in a semiconductor integrated circuit of the present invention. The electrical system of the circuitry is identical to the conventional one shown in Fig. 8. In Fig. 3, a section enclosed with a dot-dash line 111a is a portion that is formed in a p-type substrate region to have an NMOS structure. The region 111a includes a portion corresponding to a high-voltage generating means that generates a high voltage. The high-voltage generating means includes transistors M1 to M4, and capacitors C1 to C3, C11, and C12. On the other hand, a portion including a waveform shaping circuit 200 except capacitors C11 and C12 constitutes a supply voltage Vcc system, to which a high voltage Vpp is not applied. The portion belongs to the EEPROM control systems 104 and 105, which is, therefore, formed in the twin-well region 114 to have a CMOS structure.

The EEPROM memory cell array 107 shown in Fig. 1 corresponds to the aforesaid EEPROM memory cell array. The high-voltage peripheral system 108 corresponds to a high-voltage supplying means shown in Fig. 2 or a high-voltage generating means shown in Fig. 3. The EEPROM control systems 104 and 105 (control means or EEPROM control systems) correspond to the circuits of Fig. 5 except sections enclosed with dot-dash lines 111a in Fig. 2 or 3; that is, except a memory cell array 31, Vpp switches 40 and 46, a Y gate 35, and part of a Vpp generator 44. The system bus shown in Fig. 4 constitutes a system bus means.

As shown in Figs. 1A and 1B, a CPU 101, a ROM or RAM 102, a UART 103, and EEPROM control systems 104 and 105 are formed in a twin-well region 114 made up of a p-well region 112 and an n-well region 110 that are created on a p-type semiconductor substrate. This provides interchangeability with latest highly-integrated microcomputers. Furthermore, an EEPROM memory cell array 107 and an EEPROM peripheral high-voltage system 108 are formed in a p-type substrate region 111 on the above p-type semiconductor substrate. This minimizes a substrate effect and enables a high-voltage system to operate normally. Specifically, when a portion of a power supply system to which a high voltage is not applied is configured, various circuits that have already been designed for a twin-well structure permitting high integration can be used as they are. Moreover, an EEPROM can be united with the portion. This helps shorten a development time and evolve a variety of products.

When the p-type substrate region 111 is surrounded with a p-well region, a capability of withstanding a latch-up improves. This leads to little occurrence of a latch-up phenomenon.

In the aforesaid embodiment, a semiconductor integrated circuit is formed on a p-type semiconductor substrate. The present invention is not limited to this type of semiconductor integrated circuit but may be implemented in a semiconductor integrated circuit formed on an n-type semiconductor substrate. When an n-type semiconductor substrate is used, a CPU 101, a ROM or RAM 102, an UART 103, EEPROM control systems 104 and 105 are formed as CMOSs in a twin-well region created on an n-type semiconductor substrate. An EEPROM memory cell array 107 and a peripheral high-voltage system 108 are formed as PMOSs in an n-type substrate region. The n-type substrate region is surrounded with an n-well region.

In the aforesaid embodiment, a semiconductor integrated circuit for a microcomputer having a built-in EEPROM has been described. The present invention is not limited to this type of semiconductor integrated circuit. The present invention can be implemented in any type of semiconductor integrated circuit having a built-in EEPROM, and provides the same advantages as those described previously.

As described so far, in a semiconductor integrated circuit according to the present invention, a p-type substrate region and a twin-well region made up of an n-well region and a p-well region are created. An EEPROM memory cell array and a peripheral high-voltage system, to which a high voltage is applied, are formed as NMOSs in the p-type substrate region. The control system and the other components are formed as CMOSs in the twin-well region. Therefore, the high-voltage system can operate in the p-type substrate region. Various layouts of circuits that are highly integrated and designed in an advanced microcomputer manufacturing process can be adopted for the twin-well region. This helps shorten a development time and evolve a variety of products.

When a p-type substrate region is surrounded with a p-well region, a capability of withstanding a latch-up improves. This leads to little occurrence of a latch-up phenomenon, thus permitting a high reliability.

The present invention has the advantage of providing a semiconductor integrated circuit for a microcomputer having the aforesaid construction.

An object of the present invention is to provide a semiconductor integrated circuit in which an EEPROM is incorporated in a highly-integrated microcomputer having a twin-well structure.

A twin-well region 114 made up of an n-well region 110 and a p-well region 112, and a p-type substrate region surrounded with a p-well region are created on a single semiconductor substrate 100a. A supply voltage system made up of a CPU 101, a ROM or RAM 102, an UART 103, and EEPROM control systems 104 and 105, to which a high voltage of an EEPROM is not applied, is formed in the twin-well region to have a CMOS structure. This enables high integration. A high-voltage system made up of an EEPROM memory cell array 107 and an EEPROM peripheral high-voltage system 108 is formed in the p-type substrate region to have an NMOS structure. This minimizes a substrate effect and enables the high-voltage system to operate normally.

## Claims

1. A single semiconductor integrated circuit, comprising at least:

   an EEPROM memory cell array (107) in which a plurality of memory cells each including a nonvolatile memory transistor in or from which data can be written or erased electrically are arranged in the form of a matrix;
   a means that generates a high voltage necessary for writing or erasing data in or from said memory cell array;
   a means for supplying said high voltage selectively to a memory cell; and
   a means (101,..,105) that controls writing, and reading and erasing data in and from said memory cell array;
   characterised by a portion (108) including said memory cell array, and said high-voltage generating means and said high-voltage supplying means which constitute a peripheral high-voltage system of said memory cell array being formed on a p-type semiconductor substrate to have an NMOS structure or on an n-type semiconductor substrate to have a PMOS structure: and said control means (101,..,105) to which no high voltage is applied being formed as a CMOS in a twin-well region using a p well and an n well that are created on said semiconductor substrate.

2. A semiconductor integrated circuit according to claim 1, wherein said portion in which said EEPROM memory cell array, and said high-voltage generating means and said high-voltage supplying means which constitute said peripheral high-voltage system of said memory cell array are formed is surrounded with a p-well region (112a) or an n-well region that is of the same type as that of said semiconductor substrate.

3. A single semiconductor integrated circuit for a microcomputer, comprising:

   a CPU (101) for processing data;
   a ROM (102) that contains programs;
   a RAM (102) for storing data temporarily;
   an input/output unit (103) for transferring data to or from external units;

an EEPROM memory cell array (107) in which a plurality of memory cells each including a nonvolatile memory transistor in or from which data can be written or erased electrically are arranged in the form of a matrix;
a high-voltage generator that generates a high voltage necessary for writing or erasing data in or from said memory cell array;
an EEPROM peripheral high-voltage system including a high-voltage supplier that supplies said high voltage selectively to any of said memory cells;
EEPROM control systems (104) that control writing, and reading and erasing data in and from said memory cell array under the control of said CPU; and
a system bus means for interconnecting the above components;

characterised by a portion (108) which consists of said EEPROM memory cell array and said EEPROM peripheral high-voltage system and to which a high voltage is applied being formed on a p-type semiconductor substrate to have an NMOS structure or on an n-type semiconductor substrate to have a PMOS structure; and said CPU, ROM, RAM, input/output unit, and EEPROM control systems, to which no high voltage is applied, being formed as CMOSs in a twin-well region using a p well and an n well that are created on said semiconductor substrate.

4. A semiconductor integrated circuit for a microcomputer according to claim 3, wherein said portion in which said EEPROM memory cell array and said EEPROM peripheral high-voltage system are formed is surrounded with a p-well region (112a) or an n-well region that is of the same type as that of said semiconductor substrate.

## Patentansprüche

1. Einzelne integrierte Halbleiterschaltung mit zumindest

   einer regelmäßigen elektrisch lösch- und programmierbaren Festspeicher-Speicherzellenanordnung (107), in der eine Vielzahl von Speicherzellen, von denen jede einen nichtflüchtigen Speichertransistor aufweist, in den oder aus dem Daten elektrisch geschrieben oder gelöscht werden können, in der Form einer Matrix angeordnet sind,
   einer Einrichtung, die eine zum Schreiben oder Löschen von Daten in die oder aus der regelmäßigen Speicherzellenanordnung notwendige hohe Spannung erzeugt,

einer Einrichtung zur selektiven Zufuhr der hohen Spannung zu einer Speicherzelle und einer Einrichtung (101, ...,105) zur Steuerung des Schreibens, Lesens und Löschens von Daten in und aus der regelmäßigen Speicherzellenanordnung,

**gekennzeichnet durch**

einen Abschnitt (108), der die regelmäßige Speicherzellenanordnung, die Einrichtung zur Erzeugung der hohen Spannung und die Einrichtung zur Zufuhr der hohen Spannung aufweist, wobei die letzteren beiden Einrichtungen ein peripheres System der hohen Spannung der regelmäßigen Speicherzellenanordnung bilden, und der auf einem p-Typ-Halbleitersubstrat mit einer negativen Metalloxidhalbleiter-Anordnung oder auf einem n-Typ-Halbleitersubstrat mit einer positiven Metalloxidhalbleiter-Anordnung ausgebildet ist, wobei die Steuereinrichtung (101, ...,105), der die hohe Spannung nicht zugeführt wird, als ein komplementärer Metalloxidhalbleiter in einem Zwillings-Wannen-Bereich unter Verwendung einer p-Wanne und einer n-Wanne ausgebildet ist, die auf dem Halbleitersubstrat ausgebildet sind.

2.  Integrierte Halbleiterschaltung nach Anspruch 1,
    **dadurch gekennzeichnet, daß**
    der Abschnitt, in dem die regelmäßige elektrisch lösch- und programmierbare Festspeicher-Speicherzellenanordnung, die Einrichtung zur Erzeugung der hohen Spannung und die Einrichtung zur Zufuhr der hohen Spannung ausgebildet sind, wobei die letzteren beiden Einrichtungen das periphere System der hohen Spannung der regelmäßigen Speicherzellenanordnung bilden, von einem p-Wannen-Bereich (112a) oder einem n-Wannen-Bereich umgeben ist, der von demselben Typ wie der des Halbleitersubstrats ist.

3.  Einzelne integrierte Halbleiterschaltung für einen Mikrocomputer mit

    einer Zentraleinheit (101) zur Datenverarbeitung,
    einem Festspeicher (102), der Programme beinhaltet,
    einem Speicher mit wahlfreiem Zugriff (102) zum vorübergehenden Speichern von Daten,
    einer Eingabe/Ausgabe-Einheit (103) zur Datenübertragung zu oder von externen Einheiten,
    einer regelmäßigen, elektrisch lösch- und programmierbaren Festspeicher-Speicherzellenanordnung (107), in der eine Vielzahl von Speicherzellen, von denen jede einen nichtflüchtigen Speichertransistor aufweist, in den oder aus dem Daten elektrisch geschrieben oder gelöscht werden können, in der Form einer Matrix angeordnet sind,
    einer Einrichtung zur Erzeugung einer hohen Spannung, die eine zum Schreiben oder Löschen von Daten in die oder aus der regelmäßigen Speicherzellenanordnung notwendige hohe Spannung erzeugt,
    einem peripheren elektrisch lösch- und programmierbaren Festspeicher-System der hohen Spannung mit einer Einrichtung zur Zufuhr der hohen Spannung, die jeder der Speicherzellen selektiv die hohe Spannung zuführt,
    einem elektrisch lösch- und programmierbaren Festspeicher-Steuersystem (104), das das Schreiben, Lesen und Löschen von Daten in und aus der regelmäßigen Speicherzellenanordnung unter der Steuerung der Zentraleinheit steuert, und
    einer Systembuseinrichtung zur Zusammenschaltung der vorstehenden Bestandteile,

    **gekennzeichnet durch**

    einen Abschnitt (108), der aus der regelmäßigen elektrisch lösch- und programmierbaren Festspeicher-Speicherzellenanordnung und dem peripheren elektrisch lösch- und programmierbaren Festspeicher-System der hohen Spannung besteht, und dem die hohe Spannung zugeführt wird, der auf einem p-Typ-Halbleitersubstrat mit einer negativen Metalloxidhalbleiter-Anordnung oder auf einem n-Typ-Halbleitersubstrat mit einer positiven Metalloxidhalbleiter-Anordnung ausgebildet ist, wobei die Zentraleinheit, der Festspeicher, der Speicher mit wahlfreiem Zugriff, die Eingabe/Ausgabe-Einheit und die elektrisch lösch- und programmierbaren Festspeicher-Steuersysteme, denen die hohe Spannung nicht zugeführt wird, als komplementäre Metalloxidhalbleiter in einem Zwillings-Wannen-Bereich unter Verwendung einer p-Wanne und einer n-Wanne ausgebildet sind, die auf dem Halbleitersubstat ausgebildet sind.

4.  Integrierte Halbleiterschaltung für einen Mikrocomputer nach Anspruch 3,
    **dadurch gekennzeichnet, daß**
    der Abschnitt, in dem die regelmäßige elektrisch lösch- und programmierbare Festspeicher-Speicherzellenanordnung und das periphere elektrisch lösch- und programmierbare Festspeicher-System der hohen Spannung ausgebildet sind, von einem p-Wannen-Bereich (112a) oder einem n-Wannen-Bereich umgeben ist, der von demselben Typ wie der des Halbleitersubstrats ist.

**Revendications**

1.  Un circuit intégré à semiconducteurs unique, comprenant au moins :

un réseau de cellules de mémoire EEPROM (107), dans lequel un ensemble de cellules de mémoire, comprenant chacune un transistor de mémoire non volatile dans lequel des données peuvent être écrites ou effacées de façon électrique, sont disposées sous la forme d'une matrice;

un moyen qui génère une tension élevée nécessaire pour écrire ou effacer des données dans le réseau de cellules de mémoire;

un moyen pour appliquer sélectivement la tension élevée à une cellule de mémoire; et

un moyen (101, ... 105) qui commande l'écriture, la lecture et l'effacement de données dans le réseau de cellules de mémoire;

caractérisé en ce qu'une partie (108) comprenant le réseau de cellules de mémoire, ainsi que le moyen de génération de tension élevée et le moyen d'application de tension élevée, qui constituent un système périphérique à tension élevée du réseau de cellules de mémoire, est formée sur un substrat semiconducteur de type p de façon à avoir une structure NMOS, ou sur un substrat semiconducteur de type n de façon à avoir une structure PMOS; et le moyen de commande (101, ..., 105) auquel une tension élevée n'est pas appliquée, est réalisé sous la forme d'une structure CMOS dans une région à deux caissons utilisant un caisson p et un caisson n qui sont créés dans le substrat semiconducteur.

2. Un circuit intégré à semiconducteurs selon la revendication 1, dans lequel la partie dans laquelle sont formés le réseau de cellules de mémoire EEPROM, ainsi que le moyen de génération de tension élevée et le moyen d'application de tension élevée qui constituent le système périphérique à tension élevée du réseau de cellules de mémoire, est entourée par une région de caisson p (112a) ou par une région de caisson n qui est du même type que le substrat semiconducteur.

3. Un circuit intégré à semiconducteurs unique pour un micro-ordinateur, comprenant :

une unité centrale (101) pour traiter des données;

une mémoire morte (102) qui contient des programmes;

une mémoire vive (102) pour enregistrer temporairement des données;

une unité d'entrée/sortie (103) pour transférer des données vers des unités externes ou à partir de celles-ci;

un réseau de cellules de mémoire EEPROM (107) dans lequel un ensemble de cellules de mémoire, comprenant chacune un transistor de mémoire non volatile dans lequel des données peuvent être écrites ou effacées de façon électrique, sont disposées sous la forme d'une matrice;

un générateur de tension élevée qui génère une tension élevée nécessaire pour écrire ou effacer des données dans le réseau de cellules de mémoire;

un système périphérique à tension élevée pour le réseau EEPROM, comprenant un circuit d'application de tension élevée qui applique sélectivement la tension élevée à des cellules de mémoire quelconques;

des systèmes de commande de réseau EEPROM (104) qui commandent l'écriture, la lecture et l'effacement de données dans le réseau de cellules de mémoire, sous la commande de l'unité centrale; et

une structure de bus de système pour interconnecter les composants ci-dessus;

caractérisé en ce qu'une partie (108) qui comprend le réseau de cellules de mémoire EEPROM et le système périphérique à tension élevée pour le réseau EEPROM, et à laquelle une tension élevée est appliquée, est formée sur un substrat semiconducteur de type p de façon à avoir une structure NMOS, ou sur un substrat semiconducteur de type n de façon à avoir une structure PMOS; et l'unité centrale, la mémoire morte, la mémoire vive , l'unité d'entrée/sortie et les systèmes de commande de réseau EEPROM, auxquels une tension élevée n'est pas appliquée, sont réalisés sous la forme de structures CMOS dans une région à deux caissons, utilisant un caisson p et un caisson n qui sont créés dans le substrat semiconducteur.

4. Un circuit intégré à semiconducteurs pour un micro-ordinateur selon la revendication 3, dans lequel la partie dans laquelle le réseau de cellules de mémoire EEPROM et le système périphérique à tension élevée pour le réseau EEPROM sont formés, est entourée par une région de caisson p (112a) ou par une région de caisson n qui est du même type que le substrat semiconducteur.

# FIG. IA

104

100a

103 — UART

EEPROM
CONTROL
SYSTEM

108

112a

101 — CPU

EEPROM PERIPHERAL
HIGH-VOLTAGE SYSTEM

EEPROM
MEMORY
CELL
ARRAY

IB

IB

107

102 — ROM/RAM

EEPROM
CONTROL
SYSTEM

105

# FIG. IB

114

112   110   112   110   112   111   112

100a

EP 0 598 974 B1

# FIG. 2

14

FIG. 3

# FIG. 4

# FIG. 5

# FIG. 6A

# FIG. 6B

# FIG. 7

FIG. 8

EP 0 598 974 B1

# FIG. 9

| | | |
|---|---|---|
| LATCH START SIGNAL | WE | |
| WRITE START SIGNAL | CE | |
| LATCH SIGNAL | LATCH | LATCH CYCLE |
| ERASING CYCLE SIGNAL | ERS | ERASING CYCLE |
| PRE-CHARGE SIGNAL | PRCH | |
| PROGRAM CYCLE SELECTION SIGNAL | PRS | PROGRAM CYCLE |
| CONTROL GATE LINE RESET SIGNAL | CGRST | |
| BIT LINE RESET SIGNAL | BTRST | |
| CONTROL GATE LINE TRANSFER CONTROL SIGNAL | CGTR | |
| BIT SIGNAL TRANSFER CONTROL SIGNAL | BTTR | |
| ERASING CLOCK SIGNAL | CLKE | |
| PROGRAM CLOCK SIGNAL | CLKP | |
| WORD LINE CLOCK SIGNAL | CLKW | |
| HIGH-VOLTAGE SIGNAL | VPPL | Vpp |

# FIG. 10A
## PRIOR ART

| 103 — UART | 104 — EEPROM CONTROL SYSTEM | 100 |
| CPU (101) | EEPROM PERIPHERAL HIGH-VOLTAGE SYSTEM (108) |
| XB | EEPROM MEMORY CELL ARRAY (107) | XB |
| ROM/RAM (102) | EEPROM CONTROL SYSTEM — 105 |

# FIG. 10B
## PRIOR ART

110    110    111

100